# EUROPEAN PATENT SPECIFICATION

(11) **EP 3 029 471 B1**
(45) Date of publication and mention of the grant of the patent: **11.08.2021**
(21) Application number: 14196404.9
(22) Date of filing: 04.12.2014
(51) Int. Cl.: G01R 15/20, H02M 3/335

(54) **A SWITCHED MODE POWER SUPPLY CIRCUIT**
SCHALTNETZTEIL
CIRCUIT D'ALIMENTATION EN MODE COMMUTÉ

(43) Date of publication of application: 08.06.2016
(73) Proprietor: ROHM CO., LTD., Kyoto 615-8585 (JP)
(72) Inventor: Mladenova, Irina, Ukyo-ku, Kyoto 615-8585 (JP)
(74) Representative: Isarpatent

(56) References cited:
- US-A1- 2013 301 311
- US-B1- 6 424 018
- GUE RIN F ET AL: "Hybrid Modeling for Performance Evaluation of Multisource Renewable Energy Systems", IEEE TRANSACTIONS ON AUTOMATION SCIENCE AND ENGINEERING, IEEE SERVICE CENTER, NEW YORK, NY, US, vol. 8, no. 3, 1 July 2011 (2011-07-01), pages 570-580, XP011384804, ISSN: 1545-5955, DOI: 10.1109/TASE.2011.2140317
- AHMED F ABD EL-HALIM ET AL: "Practical methodology of control and protection of field oriented induction machine using digital signal processing", COMPUTER THEORY AND APPLICATIONS (ICCTA), 2012 22ND INTERNATIONAL CONFERENCE ON, IEEE, 13 October 2012 (2012-10-13), pages 122-126, XP032419062, DOI: 10.1109/ICCTA.2012.6523557 ISBN: 978-1-4673-2823-4
- None

## Description

### FIELD OF THE INVENTION

The invention relates to a switched mode power supply circuit with a galvanic isolated feedback.

### TECHNICAL BACKGROUND

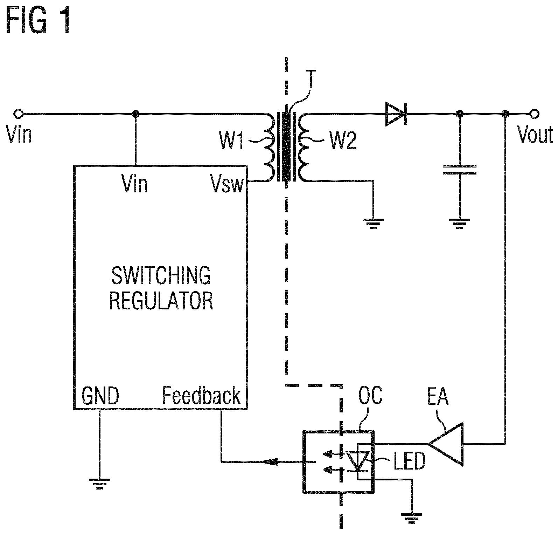

A switched mode power supply is an electronic power supply which incorporates a switching regulator to convert electrical power efficiently. Switched mode power supply circuits are known from US 2013/0301311 A1 and Guérin et al, "Hybrid Modeling for Performance Evaluation of Multisource Renewable Energy Systems", IEEE Transactions on Automation science and Engineering, 2011, p.570-580. Further, hall effect voltage sensing circuits are known from US 6,424,018 B1 and Abd El-Halim et al., "Practical Methodology of Control and Protection of Field Oriented Induction Machine Using Digital Signal Processing", Computer Theory and Applications, 2012, pages 122-126. The switched mode power supply transfers electrical power from a power source, for instance a mains power, to a load, while converting voltage and current characteristics. Conventional high voltage switched mode power supply, SMP, circuits are mainly galvanic isolated from the circuit for which they are used to generate the power supply. The switched mode power supply circuit can drive the primary winding of a high frequency transformer to convert a voltage up or down to a required output level on the secondary winding of the respective transformer. Fig. 1 shows a circuit diagram of a conventional switched mode power supply circuit. The switched mode power supply circuit comprises a transformer T having a primary winding W1 and a secondary winding W2. The transformer T is configured to convert an input voltage Vin supplied to the primary winding W1 of the transformer T into an output voltage V_{OUT} at the secondary winding W2 of the transformer T. A feedback circuit is used to control the generated output voltage V_{OUT} at the secondary winding W2 of the transformer T. For safety reasons, a galvanic connection between the two voltage domains is avoided. The galvanic isolated feedback circuit of the conventional switched mode power supply circuit illustrated in Fig. 1 comprises a switching regulator connected to the primary winding W1 of the transformer T receiving a feedback control signal from an error signal amplifier EA and an optical isolation element being an optocoupler OC forming a boundary between the two different voltage domains as illustrated in Fig. 1 by a dashed line. The error amplifier EA is used to trigger a light-emitting diode LED of the optocoupler OC in response to an error signal branched off at the output terminal of the switched mode power supply circuit. As can be seen in Fig. 1, the conventional switched mode power supply circuit comprises three integrated circuits, i.e. the switching regulator, the error amplifier EA with hysteresis and the optocoupler OC. The switched mode power supply circuit further comprises other discrete devices such as resistors and capacitors connected to the integrated circuits. The provision of three different integrated circuits within the conventional switched mode power supply circuit increases the complexity of the switched mode power supply circuit. Moreover, the required space of the switched mode power supply circuit is relatively large because of the different integrated circuits.

Accordingly, it is an object of the present invention to provide a switched mode power supply circuit with less technical complexity.

### SUMMARY OF THE INVENTION

This object is achieved by a switched mode power supply circuit comprising the features of claim 1. Advantageous embodiments are set out in the dependent claims.

In a possible embodiment of the switched mode power supply circuit according to the first aspect of the present invention, the output voltage at the secondary winding of the transformer is rectified and applied to a first terminal of the inductor via a resistor defining an electrical current flowing through said inductor to generate the magnetic field.

In a possible embodiment of the switched mode power supply circuit, the second terminal of the inductor is grounded.

In a further possible embodiment of the switched mode power supply circuit according to the first aspect of the present invention, the feedback circuit comprises a switching regulator connected to the primary winding of the transformer.

In a further possible embodiment of the switched mode power supply circuit according to the first aspect of the present invention, the feedback circuit comprises a voltage amplifier adapted to amplify a Hall voltage generated by said Hall sensor in response to the magnetic field created by said inductor of said galvanic isolated feedback circuit.

In a further possible embodiment of the switched mode power supply circuit according to the first aspect of the present invention, the amplified Hall voltage output by said voltage amplifier is supplied to said switching regulator of said feedback circuit.

The integrated feedback circuit further comprises as the inductor an on chip inductor element and as the Hall sensor an on chip Hall sensor element adapted to measure an internal magnetic field generated by said on chip inductor element and further comprising an integrated switching regulator.

The on chip inductor element and the on chip Hall sensor element are implemented in different layers of the integrated feedback circuit to provide a predetermined distance between the on chip inductor element and the on chip Hall sensor element.

The on chip inductor element comprises a coil having a rectangular or spiral form implemented as a metal layer of said integrated feedback circuit.

The feedback circuit further may further comprise an overcurrent protection circuit connected in series with the on chip inductor element.

The overcurrent protection circuit may further comprise a current sense resistor element and a low resistance switch connected to said on chip inductor element.

A voltage drop at the current sense resistor element may be sensed by a comparator element adapted to switch off the low resistance switch of the overcurrent protection circuit, if the detected voltage drop exceeds a threshold voltage.

The invention further provides according to a second aspect a DC/DC converter comprising a switched mode power supply circuit according to the first aspect of the present invention.

In a possible embodiment of the DC/DC converter according to the second aspect of the present invention, the DC/DC converter is a flyback converter comprising an output rectifier connected to a secondary winding of the transformer.

In a further possible embodiment of the DC/DC converter according to the second aspect of the present invention, the output rectifier is connected to a capacitor rechargeable during a flyback period and via said resistor to the inductor of the galvanic isolated feedback circuit.

In a possible embodiment of the DC/DC converter according to the second aspect of the present invention, the galvanic isolated feedback circuit is formed by the integrated feedback circuit.

### BRIEF DESCRIPTION OF THE FIGURES

In the following, possible embodiments of the different aspects of the present invention are described in more detail with reference to the enclosed figures.
- Fig. 1: shows a circuit diagram of a conventional switched mode power supply circuit;
- Fig. 2: shows a circuit diagram of a possible exemplary embodiment of a switched mode power supply circuit according to an aspect of the present invention;
- Fig. 3: shows a circuit diagram of a possible exemplary embodiment of a galvanic isolated feedback circuit used in the switched mode power supply circuit illustrated in Fig. 2;
- Fig. 4: shows a top view of an exemplary embodiment of an on chip inductor element within an integrated galvanic isolated feedback circuit used in the switched mode power supply circuit according to the present invention.

### DETAILED DESCRIPTION OF EMBODIMENTS

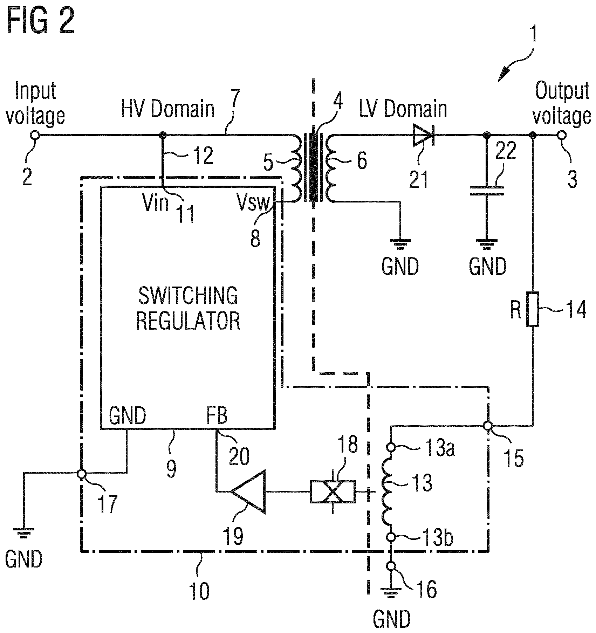

Fig. 2 shows a circuit diagram of an exemplary embodiment of a switched mode power supply circuit 1 according to the first aspect of the present invention. The switched mode power supply circuit 1 comprises an input terminal 2 for receiving an input voltage V_{IN} and an output terminal 3 for supplying an output voltage V_{OUT} to an external load. The switched mode power supply circuit 1 comprises a transformer 4 comprising a primary winding 5 and a secondary winding 6. The transformer 4 is configured to convert the input voltage Vin applied to the primary winding 5 of the transformer 4 into an output voltage at the secondary winding 6 of the transformer 4. As can be seen in Fig. 2, the primary winding 5 of the transformer 4 is connected via line 7 to the input voltage terminal 2 of the switched mode power supply circuit 1 and to a switching pin 8 of a switching regulator circuit 9 of a galvanic isolated feedback circuit 10. The galvanic isolated feedback circuit 10 comprising the switching regulator circuit 9 is configured to control the output voltage of the switched mode power supply device 1. As can be seen in Fig. 2, the switching regulator 9 comprises an input voltage pin 11 receiving the input voltage Vin at the input voltage terminal 2 via the power line 12. The galvanic isolated feedback circuit 10 further comprises an inductor 13 to which the output voltage Vout at the output voltage terminal 3 of the switched mode power supply circuit 1 is applied via a resistor 14 connected to a terminal 15 of the galvanic isolated feedback circuit 10. The resistor 14 defines an electrical current I flowing through the inductor 13 to a further terminal 16 of the galvanic isolated feedback circuit 10. In the embodiment illustrated in Fig. 2, the terminal 16 of the galvanic isolated feedback circuit 10 is connected to ground GND. Also, the switching regulator 9 of the galvanic isolated feedback circuit 10 is grounded in the illustrated embodiment via a ground terminal 17 of the galvanic isolated feedback circuit 10. The feedback circuit 10 further comprises a Hall sensor 18. The output voltage is applied to the inductor 13 of the galvanic isolated feedback circuit 10 to generate a magnetic field B measured by the Hall sensor 18 of the feedback circuit 10 to provide a control voltage used to control the output voltage at the secondary winding 6 of the transformer 4. In the illustrated embodiment, the Hall sensor 18 is connected to an error amplifier 19 providing a feedback control signal to a feedback control pin 20 of the switching regulator circuit 9. The voltage amplifier 19 is adapted to amplify a Hall voltage generated by the Hall sensor 18 in response to the magnetic field created by the inductor 13 of the feedback circuit 10. The amplified Hall voltage is output by the voltage amplifier 19 to the feedback control pin 20 of the switching regulator 9 within the feedback circuit 10. As illustrated in Fig. 2, the inductor 13 and the Hall sensor 18 form a border between a first voltage domain and a second voltage domain as illustrated by a dashed line. In a possible embodiment, the first voltage domain is a high voltage domain and the second voltage domain is a low voltage domain. In the embodiment illustrated in Fig. 2, the secondary winding 6 of the transformer 4 is connected on the one hand to ground GND and on the other hand via an output rectifier 21 to the output voltage terminal 3. Further, a capacitor 22 is connected to the output rectifier 21 as shown in Fig. 2. The capacitor 22 is connected between the output voltage terminal 3 and ground GND. The capacitor 22 can be recharged during a flyback period. In the exemplary embodiment illustrated in Fig. 2, the switched mode power supply circuit 1 forms part of a flyback DC/DC converter. The DC/DC converter is an electronic circuit which can be used either to transform one voltage level to a different voltage level or to provide an isolation barrier between two voltage domains. The DC/DC converter can for instance be used in a power distribution system to provide a local voltage conversion at a local point of load voltage.

As illustrated in Fig. 2, the galvanic isolated feedback circuit 10 comprises an inductor 13, a Hall sensor 18, an error voltage amplifier 19 and a switching regulator circuit 9. The switching regulator circuit 9 can use high-speed semiconductor switches to chop a DC input voltage into a high-frequency square wave. The switching frequency can range in a possible exemplary embodiment from 20 kHz to over 20 MHz. The switching regulator 9 can comprise a pulseless modulation circuit used to control the signal chopper or switch. This circuit can be connected to the error amplifier 19 providing a feedback voltage. By varying a duty cycle of a switch, the pulseless modulated circuit can control the delivered output voltage. In a possible embodiment, the amplified error voltage output by the error amplifier 19 provides an input voltage to a comparator within the switching regulator 9. Another input can be formed a sawtooth waveform generator. The waveform can have a period that is equal to the reciprocal of the converter switching frequency. The integrated comparator can provide a rectangular waveform which duty cycle is proportional to the output voltage level of the error amplifier 19. The rectangular waveform can be amplified and applied to a base of a semiconductor switch. In a possible embodiment, the signal controls the on-time of the semiconductor switch. The on-time of the semiconductor switch adjusts the input of the error amplifier 19 to a level equal to a reference voltage. In a possible embodiment, the voltage signal caused by the switching action of the circuit is filtered by a filter unit. The use of a switching regulator 9 provides high efficiency when compared to conventional linear controllers.

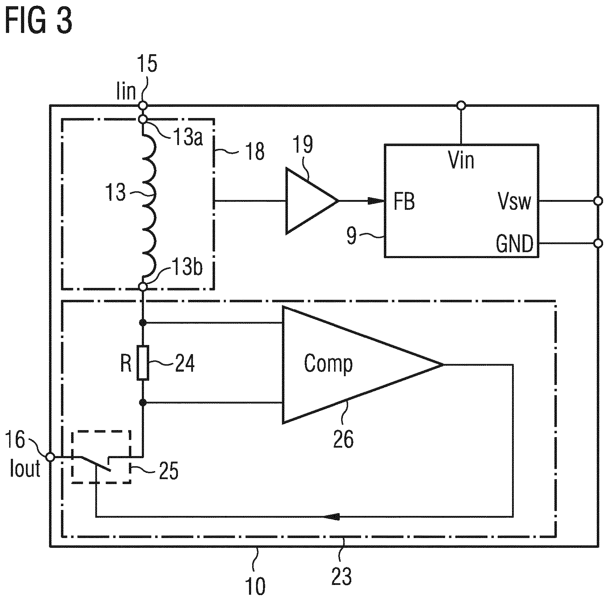

Fig. 3 shows a circuit diagram of a possible exemplary embodiment of a galvanic isolated feedback circuit 10 which can be used in the switched mode power supply circuit 1 as illustrated in Fig. 2. In the shown embodiment, the feedback circuit 10 comprises an overcurrent protection circuit 23 connected in series with the inductor 13. The overcurrent protection circuit 23 comprises a current sense resistor 24 and a low resistance switch 25. The overcurrent protection circuit 23 further comprises a comparator 26 adapted to switch off the low resistance switch 25 of the overcurrent protection circuit 23, if a detected voltage drop across the current sense resistor 24 exceeds a predetermined threshold voltage. The output signal of the comparator 26 can be delayed or processed additionally through a digital control circuit, which could force the whole device in power down mode under over-voltage conditions.

In a possible embodiment, the feedback circuit 10 is formed by an integrated circuit IC. In this embodiment, all circuit elements of the feedback circuit 10 illustrated in the embodiments of Figs. 2 or 3 are integrated circuit elements. In this embodiment, the inductor 13 is formed by an integrated inductor element and the Hall sensor 18 is formed by an integrated Hall sensor element adapted to measure an internal magnetic field B generated by the on chip inductor element 13. An advantage of the galvanic isolated feedback circuit is that all its circuit elements can be integrated in an integrated circuit. The on chip inductor element 13 and the on chip Hall sensor element 18 can be implemented in a possible embodiment in different layers of the integrated feedback circuit 10 to provide a predetermined fixed distance d between the on chip inductor element 13 and the on chip Hall sensor element 18. In a possible embodiment, the on chip inductor element 13 can be formed by a coil having a rectangular or spiral form implemented as a metal layer of the integrated feedback circuit 10.

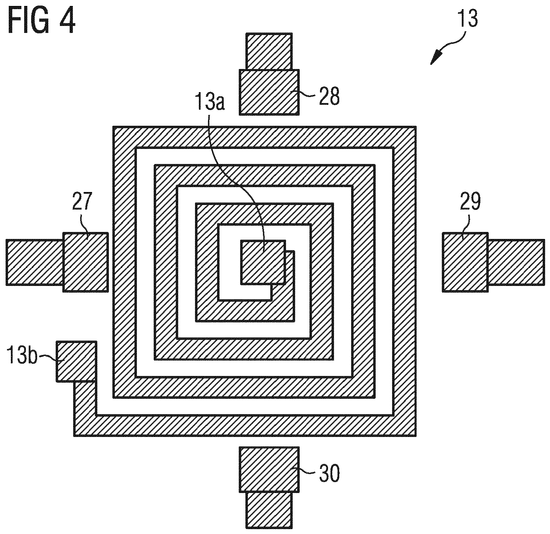

Fig. 4 illustrates an on chip inductor element 13 comprising an integrated coil having a winding form at a first and second connection terminal 13A, 13B. The first terminal 13A can be connected via the connection terminal 15 of the feedback circuit 10 to the feedback resistor 14 of the switched mode power supply circuit 1. The other terminal 13B of the integrated inductor element 13 can be connected via the terminal 16 of the feedback circuit 10 to a reference voltage, in particular ground GND. The integrated inductor element 13 can be located close to a Hall sensor plate 18 having four different connection terminals 27, 28, 29, 30 as illustrated in Fig. 4.

The feedback circuit 10 comprises an isolated topology. As can be seen in Fig. 1, the switched mode power supply circuit 1 comprises in a possible embodiment an integrated feedback circuit 10 providing an electromagnetic feedback. All elements of the feedback circuit 10 can be integrated on a single chip. Consequently, the switched mode power supply circuit 1 according to the present invention can be implemented by using a single feedback circuit chip 10. Therefore, the switched mode power supply circuit 1 according to the first aspect of the present invention can be implemented with a very low complexity and requires minimum space when used in an electronic circuit. In a further possible embodiment, the integrated feedback circuit 10 can comprise more than one integrated inductor element 13 with a corresponding Hall sensor element 18. Further embodiments are possible. In a further possible embodiment, the feedback resistor 14 is also integrated in the feedback control circuit 10. In a preferred embodiment, the distance d between the inductivity 13 and the Hall sensor 18 is fixed. In an alternative embodiment, the distance d between the inductor 13 and the Hall sensor 18 is adjustable.

## Claims

1. A switched mode power supply, SMPS, circuit (1) comprising:
a transformer (4) configured to convert an input voltage (Vin) applied to a primary winding (5) of the transformer (4) into an output voltage at a secondary winding (6) of the transformer (4); and
a galvanic isolated integrated feedback circuit (10) configured to control the output voltage at the secondary winding (6) of the transformer (4);
wherein the galvanic isolated integrated feedback circuit (10) comprises:
an on chip inductor element (13) to which the output voltage of the secondary winding (6) of the transformer (4) is applied to generate a magnetic field measured by an on chip Hall sensor (18) of that galvanic isolated feedback circuit (10) to provide a control voltage used to control the output voltage of the transformer (4); and
a switching regulator (9) connected to the primary winding (5) of the transformer (4);
wherein the on chip inductor element (13) comprises a coil having a rectangular or spiral form implemented as a metal layer of said integrated feedback circuit (10),
wherein the on chip inductor element (13) and the on chip Hall sensor element (18) are implemented in different layers of the integrated feedback circuit (10) to provide a predetermined distance between the on chip inductor element (13) and the on chip Hall sensor element (18).

2. The switched mode power supply circuit according to claim 1, wherein the output voltage of the secondary winding (6) of the transformer (4) after rectification is applied to a first terminal of said on chip inductor element (13) via a resistor (14) defining an electrical current flowing through said on chip inductor element (13) to generate the magnetic field.

3. The switched mode power supply circuit according to claim 2, wherein the second terminal of said on chip inductor element (13) is grounded.

4. The switched mode power supply circuit according to one of the preceding claims 1 to 3, wherein the feedback circuit (10) comprises a voltage amplifier (19) adapted to amplify a Hall voltage generated by said Hall sensor (18) in response to the magnetic field created by said on chip inductor element (13) of said galvanic isolated feedback circuit (10).

5. The switched mode power supply circuit according to claim 4, wherein the amplified Hall voltage output by said voltage amplifier (19) is supplied to said switching regulator (9) of said feedback circuit (10).

6. The switched mode power supply circuit according to one of the preceding claims 1 to 5, wherein the integrated feedback circuit (10) comprises an integrated overcurrent protection circuit connected in series with the on chip inductor element (13) .

7. The switched mode power supply circuit according to claim 6, wherein the overcurrent protection circuit comprises a current sense resistor element and a low resistance switch connected to said on chip inductor element (13).

8. The switched mode power supply circuit according to claim 7, wherein a voltage drop at the current sense resistor element is compared by a comparator element adapted to switch off the low resistance switch of the overcurrent protection circuit, if the detected voltage drop exceeds a threshold voltage.

9. A DC/DC converter comprising a switched mode power supply, SMPS, circuit (1) according to one of the preceding claims 1 to 8.

10. The DC/DC converter according to claim 9, wherein the DC/DC converter is a flyback converter comprising an output rectifier (21) connected to the secondary winding (6) of the transformer (4).

11. The DC/DC converter according to claim 10, wherein the output rectifier (21) is connected to a capacitor (22) rechargeable during a flyback period and via said resistor (14) to the inductor (13) of the galvanic isolated feedback circuit (10) .

## Patentansprüche

1. Schaltnetzteil (Switched Mode Power Supply, SMPS)-Stromkreis (1), umfassend:
einen Transformator (4), der dafür eingerichtet ist, eine an eine Primärwicklung (5) des Transformators (4) angelegte Eingangsspannung (Vin) in eine Ausgangsspannung an einer Sekundärwicklung (6) des Transformators (4) umzuwandeln; und
einen galvanischen isolierten integrierten Rückkopplungskreis (10), der dafür eingerichtet ist, die Ausgangsspannung an der Sekundärwicklung (6) des Transformators (4) zu steuern;
wobei der galvanische isolierte integrierte Rückkopplungskreis (10) umfasst:
ein On-Chip-Induktivitätselement (13), an das die Ausgangsspannung der Sekundärwicklung (6) des Transformators (4) angelegt wird, um ein Magnetfeld zu generieren, das durch einen On-Chip-Hall-Sensor (18) jenes galvanischen isolierten Rückkopplungskreises (10) gemessen wird, um eine Steuerspannung bereitzustellen, die zum Steuern der Ausgangsspannung des Transformators (4) verwendet wird; und
einen Schaltregler (9), der mit der Primärwicklung (5) des Transformators (4) verbunden ist;
wobei das On-Chip-Induktivitätselement (13) eine Spule mit einer Rechteck- oder Spiralform umfasst, die als eine Metallschicht des integrierten Rückkopplungskreises (10) implementiert ist,
wobei das On-Chip-Induktivitätselement (13) und das On-Chip-Hall-Sensorelement (18) in verschiedenen Schichten des integrierten Rückkopplungskreises (10) implementiert sind, um eine zuvor festgelegte Distanz zwischen dem On-Chip-Induktivitätselement (13) und dem On-Chip-Hall-Sensorelement (18) bereitzustellen.

2. Schaltnetzteil-Stromkreis nach Anspruch 1, wobei die Ausgangsspannung der Sekundärwicklung (6) des Transformators (4) nach der Gleichrichtung über einen Widerstand (14), der einen elektrischen Strom definiert, der durch das On-Chip-Induktivitätselement (13) fließt, an einen ersten Anschluss des On-Chip-Induktivitätselements (13) angelegt wird, um das Magnetfeld zu generieren.

3. Schaltnetzteil-Stromkreis nach Anspruch 2, wobei der zweite Anschluss des On-Chip-Induktivitätselements (13) geerdet ist.

4. Schaltnetzteil-Stromkreis nach einem der vorangehenden Ansprüche 1 bis 3, wobei der Rückkopplungskreis (10) einen Spannungsverstärker (19) umfasst, der dafür ausgelegt ist, eine durch den Hallsensor (18) generierte Hall-Spannung in Reaktion auf das durch das On-Chip-Induktivitätselement (13) des galvanischen isolierten Rückkopplungskreises (10) generierte Magnetfeld zu verstärken.

5. Schaltnetzteil-Stromkreis nach Anspruch 4, wobei die durch den Spannungsverstärker (19) ausgegebene verstärkte Hall-Spannung in den Schaltregler (9) des Rückkopplungskreises (10) eingespeist wird.

6. Schaltnetzteil-Stromkreis nach einem der vorangehenden Ansprüche 1 bis 5, wobei der integrierte Rückkopplungskreis (10) einen integrierten Überstromschutzkreis umfasst, der mit dem On-Chip-Induktivitätselement (13) in Reihe geschaltet ist.

7. Schaltnetzteil-Stromkreis nach Anspruch 6, wobei der Überstromschutzkreis ein Stromabfühlwiderstandselement und einen widerstandsarmen Schalter umfasst, der mit dem On-Chip-Induktivitätselement (13) verbunden ist.

8. Schaltnetzteil-Stromkreis nach Anspruch 7, wobei ein Spannungsabfall an dem Stromabfühlwiderstandselement durch ein Komparatorelement verglichen wird, das dafür ausgelegt ist, den widerstandsarmen Schalter des Überstromschutzkreises auszuschalten, falls der detektierte Spannungsabfall eine Schwellenspannung überschreitet.

9. Gleichstrom/Gleichstrom-Wandler, der einen Schaltnetzteil (Switched Mode Power Supply, SMPS)-Stromkreis (1) nach einem der vorangehenden Ansprüche 1 bis 8 umfasst.

10. Gleichstrom/Gleichstrom-Wandler nach Anspruch 9, wobei der Gleichstrom/Gleichstrom-Wandler ein Sperrwandler ist, der einen Ausgangsgleichrichter (21) umfasst, der mit der Sekundärwicklung (6) des Transformators (4) verbunden ist.

11. Gleichstrom/Gleichstrom-Wandler nach Anspruch 10, wobei der Ausgangsgleichrichter (21) mit einem während eines Sperrzeitraums wiederaufladbaren Kondensator (22) und über den Widerstand (14) mit der Induktivität (13) des galvanischen isolierten Rückkopplungskreises (10) verbunden ist.

## Revendications

1. Circuit d'alimentation en mode commuté, SMPS (1) comprenant :
un transformateur (4) configuré pour convertir une tension d'entrée (Vin) appliquée à un enroulement primaire (5) du transformateur (4) en une tension de sortie au niveau d'un enroulement secondaire (6) du transformateur (4) ; et
un circuit de rétroaction intégré à isolation galvanique (10) configuré pour commander la tension de sortie au niveau de l'enroulement secondaire (6) du transformateur (4) ;
dans lequel le circuit de rétroaction intégré à isolation galvanique (10) comprend :
un élément d'inducteur sur puce (13) auquel est appliquée la tension de sortie de l'enroulement secondaire (6) du transformateur (4) pour générer un champ magnétique mesuré par un capteur à effet Hall sur puce (18) de ce circuit de rétroaction à isolation galvanique (10) pour fournir une tension de commande utilisée pour commander la tension de sortie du transformateur (4) ; et
un régulateur de commutation (9) connecté à l'enroulement primaire (5) du transformateur (4) ;
dans lequel l'élément d'inducteur sur puce (13) comprend une bobine ayant une forme rectangulaire ou en spirale mise en œuvre sous la forme d'une couche de métal dudit circuit de rétroaction intégré (10),
dans lequel l'élément d'inducteur sur puce (13) et l'élément de capteur à effet Hall sur puce (18) sont mis en œuvre dans des couches différentes du circuit de rétroaction intégré (10) pour prévoir une distance prédéterminée entre l'élément d'inducteur sur puce (13) et l'élément de capteur à effet Hall sur puce (18).

2. Circuit d'alimentation en mode commuté selon la revendication 1, dans lequel la tension de sortie de l'enroulement secondaire (6) du transformateur (4) après redressement est appliquée à une première borne dudit élément d'inducteur sur puce (13) via un résistor (14) définissant un courant électrique circulant à travers ledit élément d'inducteur sur puce (13) pour générer le champ magnétique.

3. Circuit d'alimentation en mode commuté selon la revendication 2, dans lequel la seconde borne dudit élément d'inducteur sur puce (13) est mise à la terre.

4. Circuit d'alimentation en mode commuté selon l'une des revendications 1 à 3 précédentes, dans lequel le circuit de rétroaction (10) comprend un amplificateur de tension (19) adapté pour amplifier une tension de Hall générée par ledit capteur à effet Hall (18) en réponse au champ magnétique créé par ledit élément d'inducteur sur puce (13) dudit circuit de rétroaction à isolation galvanique (10).

5. Circuit d'alimentation en mode commuté selon la revendication 4, dans lequel la tension de Hall amplifiée délivrée en sortie par ledit amplificateur de tension (19) est fournie audit régulateur de commutation (9) dudit circuit de rétroaction (10).

6. Circuit d'alimentation en mode commuté selon l'une des revendications 1 à 5 précédentes, dans lequel le circuit de rétroaction intégré (10) comprend un circuit de protection de surintensité intégré connecté en série avec l'élément d'inducteur sur puce (13).

7. Circuit d'alimentation en mode commuté selon la revendication 6, dans lequel le circuit de protection de surintensité comprend un élément de résistor de captage de courant et un commutateur à faible résistance connectés audit élément d'inducteur sur puce (13).

8. Circuit d'alimentation en mode commuté selon la revendication 7, dans lequel une chute de tension au niveau de l'élément de résistor de captage de courant est comparée par un élément de comparateur adapté pour mettre hors tension le commutateur de faible résistance du circuit de protection de surintensité, si la chute de tension détectée dépasse une tension seuil.

9. Convertisseur CC/CC comprenant un circuit d'alimentation en mode commuté, SMPS (1) selon l'une des revendications 1 à 8 précédentes.

10. Convertisseur CC/CC selon la revendication 9, dans lequel le convertisseur CC/CC est un convertisseur à transfert indirect comprenant un redresseur de sortie (21) connecté à l'enroulement secondaire (6) du transformateur (4).

11. Convertisseur CC/CC selon la revendication 10, dans lequel le redresseur de sortie (21) est connecté à un condensateur (22) rechargeable pendant une période de retour et via ledit résistor (14) à l'inducteur (13) du circuit de rétroaction à isolation galvanique (10).
